Europäisches Patentamt

European Patent Office

Office européen des brevets

(19)

(11) **EP 1 067 392 B1**

(12) **FASCICULE DE BREVET EUROPEEN**

(45) Date de publication et mention
de la délivrance du brevet:
**05.03.2003 Bulletin 2003/10**

(51) Int Cl.[7]: **G01R 31/28**, G01R 31/01

(21) Numéro de dépôt: **00401863.6**

(22) Date de dépôt: **29.06.2000**

(54) **Procédé de tests de composants électroniques**

Verfahren zum Prüfen von elektronischen Komponenten

Method for testing electronic components

(84) Etats contractants désignés:
**AT BE CH CY DE DK ES FI FR GB GR IE IT LI LU
MC NL PT SE**

(30) Priorité: **05.07.1999 FR 9909055**

(43) Date de publication de la demande:
**10.01.2001 Bulletin 2001/02**

(73) Titulaire: **Softlink
91410 Dourdan (FR)**

(72) Inventeur: **Lejeune, Philippe, Domicilié Cabinet
95000 Cergy (FR)**

(74) Mandataire: **Schmit, Christian Norbert Marie
Cabinet Christian Schmit et Associés,
8, place du Ponceau
95000 Cergy (FR)**

(56) Documents cités:
**WO-A-97/45748          US-A- 4 686 628**

**Description**

La présente invention a pour objet un procédé de tests de composants électroniques. Elle trouve plus particulièrement son utilisation dans le domaine des tests de composants électroniques semi-conducteurs, notamment des composants tels que des circuits intégrés. Dans l'état de la technique, on connaît un procédé de test de composants électroniques qui permet une réduction du temps de test unitaire de chacun des composants. L'intérêt de l'invention est qu'elle propose un procédé de test permettant d'une part de réduire le temps de test unitaire et d'autre part d'optimiser un niveau de rendement de la production testé.

L'invention consiste en un perfectionnement de la demande internationale WO 97/45748, publiée le 4 décembre 1997. Un composant électronique comporte généralement plusieurs fonctions. Il est donc soumis à une série de tests pour tester chacune de ses fonctions. Le procédé de test selon le document WO 97/45748 peut être appliqué à chacun des tests d'une telle série. Un test comporte généralement plusieurs étapes élémentaires successives. Ainsi un procédé de test d'un composant électronique comporte les étapes élémentaires suivantes :

- à une date initiale Di, on soumet des bornes du composant, considérées comme bornes d'entrée vis à vis du test, à un potentiel électrique Vi,
- on attend pendant un délai, qu'une réponse apparaisse et se stabilise à des bornes de ce composant, considérées comme des bornes de sortie vis à vis de ce test,
- à la fin de ce délai, à une date de mesure Dm, on mesure cette réponse. Dans un exemple on mesure une valeur Vs d'un potentiel à ces bornes de sortie.

Au cours du test, le composant a ainsi été soumis à un signal, et la réponse du composant à ce signal a été mesurée au bout d'un certain délai. Ensuite pour déterminer si le composant a donné un résultat acceptable, ou non acceptable, pour ce test,

- on compare la réponse mesurée à des critères d'acceptation fixés. Soit dans cet exemple, on compare la valeur du potentiel Vs à des limites inférieures et ou supérieures d'acceptation.

Le composant électronique ayant une structure connue, on peut déterminer de manière théorique le délai au bout duquel on peut observer une réponse attendue aux bornes de sortie du composant suite à l'application d'un potentiel Vi aux bornes d'entrée de ce composant. Ce délai théorique étant connu, par exemple calculé par le concepteur du composant électronique, on détermine une date de mesure nominale Do pour ce test. La date de mesure nominale Do est une date postérieure à la date initiale Di. De plus, la date de mesure nominale est telle que la durée s'écoulant entre la date initiale Di et cette date nominale Do est supérieure à la durée du délai théorique. En effet, pour définir cette date nominale Do on choisit une marge de sécurité.

Ensuite, la date nominale Do est utilisée comme date de mesure Dm pour les composants à tester. Ce choix, privilégiant la garantie d'un résultat conforme au test, a pour conséquence d'augmenter la durée totale de réalisation du test. Ceci étant vrai pour tous les tests de la série de tests appliqués au composant, la durée globale de test d'un tel composant est donc très considérablement augmentée.

Dans la demande internationale WO 97/45748, on prévoit un procédé de test permettant de diminuer le délai entre la date initiale Di et la date de mesure Dm. En effet, le procédé de test étant destiné à être appliqué de manière consécutive à des milliers, voire plus, de composants électroniques eux-mêmes réalisés en lots, le procédé de test appliqué à l'ensemble de ces composants comporte selon ce document :

- une première « phase d'apprentissage », et
- une deuxième « phase d'application ».

Dans la phase d'apprentissage, on considère une population de composants acceptables du lot à tester. Les composants acceptables sont ceux qui ont donné un résultat correct au test effectué avec une date de mesure Dm égale à la date de mesure nominale Do. Cette population constitue une population d'apprentissage. Dans un exemple, cette population d'apprentissage peut comporter un unique composant électronique.

Ensuite, on cherche à définir, à partir de résultats obtenus sur cette population d'apprentissage, une date de mesure la plus précoce possible. Pour cela, on réitère le test déjà effectué sur cette population d'apprentissage, en appliquant à nouveau un signal aux bornes d'entrée, et en lisant la valeur du potentiel Vs aux bornes de sortie à une date de mesure intermédiaire Dmi, de préférence antérieure à la date de mesure nominale Do. Si la population d'apprentissage comporte un unique composant, on réitère un même test en utilisant une même date de mesure Dmi ou Do pour obtenir plusieurs résultats pour chacune des dates testées.

Ainsi, on procède de manière dichotomique ou pas à pas pour tester des dates de mesure antérieures à la date nominale. Pour choisir une date de mesure parmi ces dates de mesure intermédiaires Dmi testées, on compare :

- une image statistique des résultats de cette population d'apprentissage, obtenus avec une date de mesure intermédiaire Dmi, à
- une image statistique des résultats de cette même population d'apprentissage, obtenus à la date de mesure nominale Do.

En effet, pour chaque date de mesure intermédiaire Dmi testée, on détermine une image statistique des résultats obtenus. Cette image statistique comporte notamment le calcul de la moyenne M, et de l'écart type S. Par ailleurs, pour comparer deux images statistiques entre elles, on utilise un critère d'appréciation statistique nécessitant la connaissance des moyennes et écart types des images à comparer. On définit ainsi un critère d'appréciation noté CPi pour chaque image statistique obtenue pour une date de mesure Dmi. Dans un exemple, ce critère d'appréciation CPi est égal à un rapport d'une différence de limite à l'écart-type. La différence des limites peut être fournie par une tolérance fabricant, soit par exemple To. Alors CPi est égale à To divisé par S.

Pour comparer les images statistiques entre elles, on compare leur critère d'appréciation CPi respectif. On choisit comme date de mesure, la date de mesure intermédiaire Dmi la plus précoce possible. Cette date de mesure est par ailleurs telle que le critère d'appréciation CPi soit dans une certaine proportion du critère d'appréciation CPo, où CPo est le critère d'appréciation caractérisant l'image statistique des valeurs mesurées à la date nominale Do.

L'ensemble des images statistiques déterminées pour chacune des dates de mesure intermédiaire donne une représentation de l'évolution des valeurs mesurées aux bornes de sortie après avoir imposé un signal Vi aux bornes d'entrée de ce composant.

Dans un premier exemple, si pour toutes les dates de mesure intermédiaire Dmi testées, on observe une gamme large de valeurs du potentiel mesuré aux bornes de sortie, sans qu'aucune valeur ne prédomine, cela signifie que le comportement du composant électronique à ce test avec ces dates de mesure n'est pas fiable. En effet, jusqu'à la date de mesure nominale Do, les potentiels sont fluctuants et ne sont jamais correctement stabilisés. Dans ce cas, il est impossible de choisir une date de mesure inférieure à la date de mesure nominale.

Dans un deuxième exemple, également défavorable, même à la date de mesure nominale Do, on observe une courbe de représentation des valeurs de potentiel mesurées en sortie non stabilisée. Alors il faut choisir une date de mesure qui soit supérieure à cette date nominale.

Dans un troisième exemple, la représentation de l'évolution des valeurs mesurées à la sortie du composant électronique est une courbe au tracé fin. Alors il est possible de considérer des dates de mesure intermédiaires qui soient corrélées avec la date de mesure nominale. Néanmoins, même dans cet exemple, on peut définir une date de mesure minimale, en deçà de laquelle les images statistiques des résultats obtenus avec des dates de mesure inférieures à cette date minimale n'ont pas de cohérence. Par exemple, le résultat observé avec la date de mesure intermédiaire doit rester dans des limites d'acceptation imposées aux résultats obtenus avec la date de mesure nominale.

Le procédé de test prévoit de choisir une date de mesure intermédiaire la plus précoce possible. Mais le procédé prévoit que cette date de mesure intermédiaire soit toutefois supérieure à la date minimale.

Ensuite cette date de mesure intermédiaire choisie pendant la phase d'apprentissage est appliquée comme date de mesure Dm pour tous les autres composants électroniques à tester. Cette date de mesure intermédiaire est donc appliquée de manière continue pendant la phase d'application.

La solution proposée dans la demande internationale WO 97/45748, présente plusieurs problèmes. Un premier problème de ce procédé consiste à devoir effectuer une phase d'apprentissage préalable à l'exécution du test d'un lot de composants. Or cette phase d'apprentissage est longue. Elle constitue une perte de temps. De plus, la date de mesure intermédiaire déterminée au cours de cette phase d'apprentissage peut être la cause d'un taux de rejet plus important des composants électroniques testés au cours de la phase d'application.

Etant donné la durée de la phase d'apprentissage, elle ne peut pas être réalisée trop fréquemment. Le procédé conduit donc à appliquer une date de mesure non adaptée à une partie du lot à tester. La phase d'apprentissage ne permet pas de donner la date de mesure intermédiaire optimale vis-à-vis de la réduction du temps de test et également optimale vis-à-vis de la rentabilité de la production testée. En effet, si la phase d'apprentissage a abouti à choisir une date de mesure intermédiaire trop précoce, alors de nombreux composants électroniques vont échouer au test effectué avec cette date de mesure pendant la phase d'application. Ces composants vont alors être injustement écartés de la production correcte, et la rentabilité finale de la production testée sera moins bonne que la rentabilité qui aurait été obtenue suite à la réalisation d'un test avec une date de mesure plus tardive.

L'invention a pour objet de remédier aux problèmes cités en proposant un procédé de test comportant une unique phase d'apprentissage dont l'enseignement puisse être réutilisé au cours de la phase d'application du procédé de test. Par ailleurs, le procédé de test selon l'invention propose des phases d'ajustage de la date de mesure au cours de la phase d'application. Ainsi, régulièrement, par exemple au bout d'un nombre donné de pièces testées, on effectue l'ajustage de la date de mesure afin que celle-ci soit toujours optimisée vis-à-vis de la durée de test de la production en cours, et optimisée vis à vis de la rentabilité de cette production testée. En effet, les caractéristiques de la production étant variables au cours du temps, une même date de mesure ne peut être appliquée continûment. Il est nécessaire d'adapter la date de mesure aux caractéristiques spécifiques de la production à tester. En effet, les caractéristiques de la production à tester peuvent être différentes au cours du temps. Et pour autant il n'est pas nécessaire d'écarter ces parties de la production de la population des composants corrects.

D'autre part, l'invention propose un procédé de test dans lequel la date de mesure à appliquer à un lot de composant est déterminée en tenant compte des caractéristiques intrinsèques des composants à tester. Pour cela, on considère, pour déterminer la date de mesure la plus précoce possible, une population cumulée au moyen d'un critère. La population cumulée comporte un ou plusieurs composants.

Dans un premier exemple, une image statistique de cette population cumulée comporte des résultats de ce ou ces composants obtenus avec des dates de mesure distinctes. La considération de la population cumulée selon ce premier exemple peut être aussi bien utilisée pendant une phase d'apprentissage que pendant une phase d'ajustage. Notamment,

- on teste les composants de la population « cumulée » à la date de mesure nominale
- on détermine une image statistique nominale,
- on teste les mêmes composants à des dates de mesure intermédiaires,
- on considère une image statistique de la population cumulée comportant ensemble les résultats obtenus avec la date de mesure nominale et ceux obtenus avec une date de mesure intermédiaire,
- on compare l'image statistique de la population cumulée à l'image statistique nominale au moyen d'un critère pour déterminer si la date de mesure intermédiaire incorporée dans la population cumulée peut être retenue comme date de mesure pour la phase d'application.

Dans une variante, une image statistique de cette population cumulée comporte des résultats de composants issus d'origines distinctes, mais testés avec des mêmes dates de mesure. Alors, cette population cumulée comporte d'une part les composants corrects analysés au cours de la phase d'apprentissage, et d'autre part des composants corrects de la phase d'ajustage. Les composants de la phase d'ajustage sont des composants corrects issus de la production testée au cours de la phase d'application.

Pendant cette phase d'ajustage, on considère une population de composants corrects. Pour chaque phase d'ajustage, on considère une population cumulée.

Pour les composants de la phase d'apprentissage, on connaît pour chacun les valeurs mesurées obtenues aux différentes dates de mesure. Par contre, pour les composants corrects considérés lors de la phase d'ajustage, initialement, on ne connaît que la valeur mesurée à la date de mesure nominale. Seuls les composants corrects pour une date de mesure nominale peuvent être inclus dans la population de la phase d'ajustage. Pour ces composants de la phase d'ajustage, on cherche à établir la valeur mesurée à des dates de mesure intermédiaires plus précoces que la date de mesure nominale. Pour chacun des composants contenus dans la population de la phase d'ajustage, on procède individuellement à la démarche suivante :

- on détermine la valeur du potentiel mesuré avec différentes dates de mesure intermédiaire,
- pour chaque date de mesure intermédiaire testée, on inclut le résultat du composant considéré à la répartition des résultats de la population d'apprentissage, obtenus pour cette date de mesure intermédiaire,
- on considère une image statistique de cette population cumulée de valeurs obtenues à une date de mesure identique,
- on compare cette image statistique de la population cumulée, au moyen d'un critère, à une image statistique de la population d'apprentissage pour des valeurs obtenues à cette même date de mesure intermédiaire,
- on choisit une date de mesure intermédiaire ajustée telle que cette date de mesure ajustée soit supérieure ou égale à la date de mesure la plus précoce déterminée pour la population d'apprentissage, et telle qu'un critère d'appréciation de l'image statistique obtenue pour la population cumulée soit acceptable en comparaison d'un critère d'appréciation de l'image statistique de la population d'apprentissage obtenue pour cette même date de mesure ajustée.

L'invention a donc pour objet un procédé de test de composants électroniques dans lequel

- on soumet à une date initiale des bornes d'un composant à un potentiel électrique,
- on mesure, à une date de mesure, une valeur de potentiel établi à des bornes de ce composant, et
- on compare cette valeur de potentiel mesurée à des limites d'acceptation, pour accepter ou rejeter le composant en fonction de cette comparaison,
- la date de mesure est déterminée, au cours d'une phase d'apprentissage préalable à une phase d'application, au moyen d'un critère appliqué à une population de composants acceptés, en considérant une image statistique de cette population de composants acceptés,

- on retient comme date de mesure une date la plus précoce possible,

  caractérisé en ce que

- la date de mesure déterminée est ajustée au cours d'au moins une phase d'ajustage pendant la phase d'application.

L'invention a également pour objet un procédé de test de composants électroniques dans lequel

- on soumet à une date initiale des bornes d'un composant à un potentiel électrique,
- on mesure, à une date de mesure, une valeur de potentiel établi à des bornes de ce composant, et
- on compare cette valeur de potentiel mesurée à des limites d'acceptation, pour accepter ou rejeter le composant en fonction de cette comparaison,
- la date de mesure est déterminée au moyen d'un critère appliqué à une population de composants acceptés, en considérant une image statistique de cette population de composants acceptés,
- on retient comme date de mesure une date la plus précoce possible,

  caractérisé en ce que

- la population de composants acceptés considérée est une population cumulée comportant un cumul d'une population de référence et d'une population de composants corrects extraits d'une phase d'application.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :

- Figure 1: une représentation des composants d'une population d'apprentissage, d'une population d'ajustage et d'une population d'application selon l'invention ;
- Figure 2 : un diagramme chronologique représentant l'agencement dans le temps de la phase d'apprentissage, des phases d'ajustage et des phases d'application selon l'invention ;
- Figure 3 : une représentation de la répartition des résultats du test d'une population d'apprentissage selon l'invention, pour des dates de mesure testées ;
- Figure 4 : une représentation de l'évolution des résultats de test d'une population d'apprentissage selon l'invention, en fonction de la date de mesure ;
- Figure 5 : une représentation de la répartition des résultats du test d'une population d'ajustage selon l'invention, pour des dates de mesure testées ;
- Figure 6: un diagramme représentant l'évolution du critère de comparaison dans l'invention des critères d'appréciation des différentes images statistiques selon l'invention.

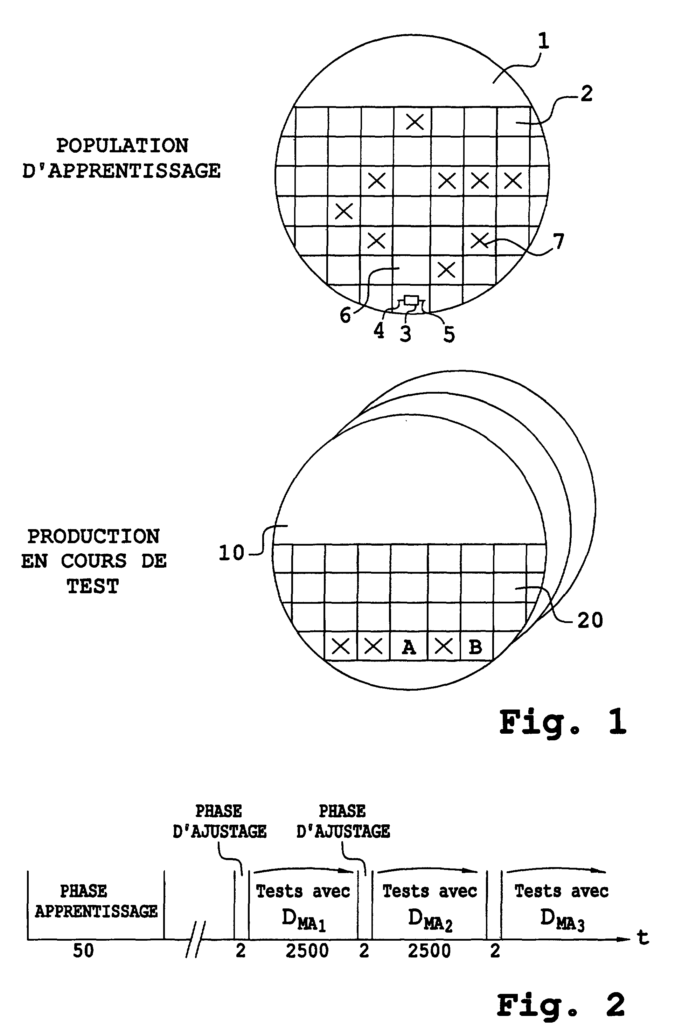

La figure 1 présente une plaquette 1 supportant des composants électroniques 2. La plaquette 1 peut également être appelée gaufrette ou "wafer". Cette plaquette peut avoir une forme circulaire ou bien une forme parallélépipèdique dite en réglette. Les composants électroniques 2 de la plaquette 1 sont par exemple des puces de circuits intégrés. Un composant électronique 2 comporte au moins une fonction 3 à tester. Pour tester la fonction 3 du composant électronique 2, on applique un potentiel Vi à des bornes conductrices 4 du composant électronique 2. Les bornes 4 sont considérées comme des bornes d'entrée pour effectuer le test de la fonction 3. Le composant électronique 2 comporte des bornes conductrices 5. Ces bornes conductrices 5 sont des bornes de sortie pour le test effectué.

En effet, on attend une réponse au test au niveau des bornes 5. Une réponse attendue au niveau des bornes 5 est généralement la valeur d'un potentiel de sortie Vs. Pour tester la fonction 3 du composant électronique 2, on utilise un appareil de test comportant un premier jeu d'électrodes venant appliquer le potentiel Vi aux bornes d'entrée 4, et un deuxième jeu d'électrodes venant capter le potentiel de sortie Vs aux bornes de sortie 5. Une interface de l'appareil de test permet de gérer l'émission de signaux électriques et la mesure de signaux captés. L'interface est configurée par des moyens de test de l'appareil de test. La configuration de l'interface permet de traiter les signaux envoyés et reçus par elles. Notamment, l'interface permet de décider si un composant est bon ou mauvais vis à vis du test réalisé.

Dans une première phase d'apprentissage, présentée figure 2, des composants électroniques sont testés avec une date de mesure égale à la date de mesure nominale Do. Les tests réalisés avec une date de mesure nominale Do sont identiques à ceux réalisés dans l'état de la technique. Dans l'invention, suite à ce premier test, on identifie des composants acceptables 6 et des composants non acceptables 7 sur la plaquette 1. Seuls les composants acceptables 6 sont considérés pour former une population d'apprentissage. En général, la population d'apprentissage comporte un seul composant.

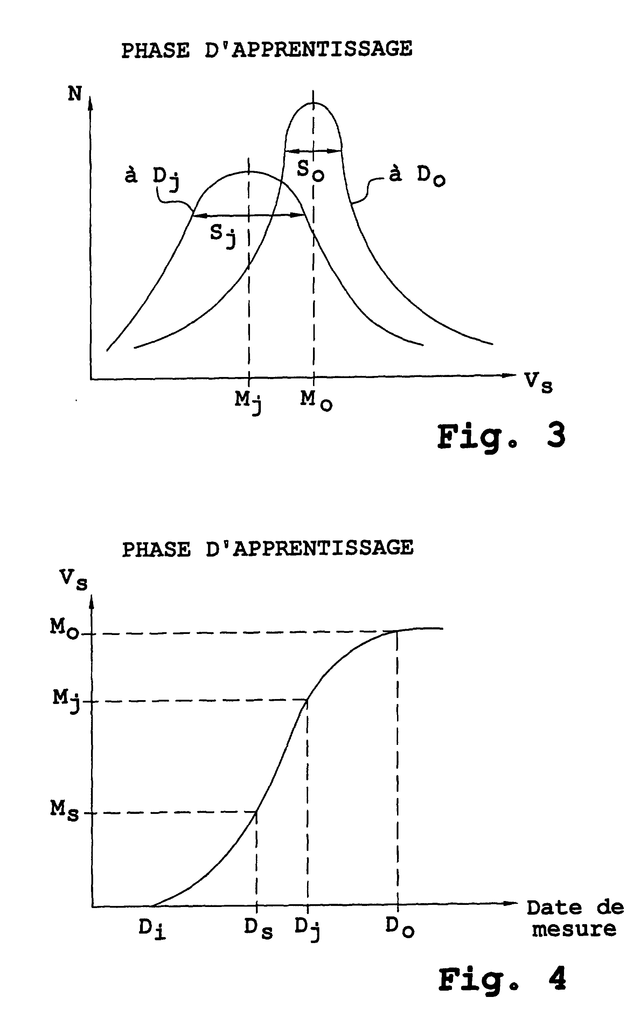

La figure 3 donne une représentation de la répartition des composants de la population d'apprentissage en fonction de la valeur Vs lue à une date de mesure nominale Do. Cette répartition est généralement gaussienne. Elle est une image statistique, établie pour une date de mesure donnée, de la population d'apprentissage. Cette répartition est caractérisée par la valeur d'une moyenne Mo et d'un écart type So. Etant donné que la date de mesure nominale Do est choisie avec une marge de sécurité importante, l'écart type So est généralement faible.

Ensuite, on détermine la répartition des composants de cette population d'apprentissage en fonction de la valeur Vs lue aux bornes de sortie des composants pour différentes dates de mesure intermédiaires. Ces dates de mesure sont de préférence antérieures à la date de mesure nominale Do. On définit ainsi des images statistiques de la population d'apprentissage pour des dates de mesure intermédiaires antérieures. Par exemple, comme représenté sur la figure 3, on obtient une représentation de la répartition de la population d'apprentissage pour une date de mesure Dj, plus précoce que la date de mesure nominale Do. Cette répartition, ou image statistique, à la date de mesure Dj est caractérisée par une moyenne Mj et un écart type Sj. La représentation de la répartition à la date de mesure Dj peut être différente de la répartition observée à la date de mesure nominale. En effet, l'écart type Sj peut être différent de l'écart type So. Généralement, l'écart type Sj, obtenu pour une date de mesure Dj antérieure à la date nominale Do, est supérieur à l'écart type So. De plus, dans le cas où le comportement d'un composant électronique vis à vis du test effectué ne serait pas parfaitement répétable, on observera une diminution progressive de l'écart type au fur et à mesure que l'on se rapproche de la date de mesure nominale.

Dans une variante, on peut considérer pour chaque date de mesure intermédiaire, une image statistique cumulée intermédiaire comportant à la fois des résultats (la valeur Vs) obtenus par ces composants à la fois à la date de mesure nominale et à la fois à la date de mesure intermédiaire. De la même manière que sur la figure 3, on peut obtenir une image statistique cumulée intermédiaire du type de celle caractérisée par l'écart type Dj et la moyenne Mj.

Figure 4, on représente un exemple d'évolution simple de la moyenne des valeurs Vs observées pour la population d'apprentissage en fonction de la date de mesure utilisée. On observe dans cet exemple une augmentation croissante de la moyenne Ms, et on constate qu'au-delà d'une date de mesure nominale Do, la valeur du potentiel observé Vs reste égale à la moyenne Mo

Par ailleurs, on peut définir une date de mesure Ds, date seuil minimum, en dessous de laquelle, la répartition de la population d'apprentissage en fonction de la valeur Vs lue à la borne de sortie 5 n'est plus cohérente. En effet, l'écart type Ss de la population d'apprentissage à cette date Ds, est trop grand pour pouvoir permettre une interprétation des données obtenues. Dans une variante, cette date Ds peut être définie en fonction de la moyenne Ms par rapport à des critères fixés.

Ainsi, au cours de la phase d'apprentissage, on choisit la date de mesure Dj la plus précoce possible. Dj est choisi entre la valeur seuil minimum Ds et la valeur nominale Do.

Pour choisir la date de mesure Dj, on peut utiliser le procédé de test présenté dans la demande internationale WO 97/45748, notamment en utilisant un critère d'appréciation CPK. Pour chaque date de mesure, on peut déterminer un CPK distinct. Ainsi on peut calculer un CPKo correspondant aux données relatives à la population d'apprentissage pour la date de mesure nominale Do. On peut également calculer des critères d'appréciation CPKj pour chaque date de mesure Dj. On peut dans une variante, calculer des critères d'appréciation CPKjc pour les images statistiques cumulées intermédiaires représentant respectivement chaque date de mesure intermédiaire. En général, on définit CPK de la manière suivante :

$$CPK = MIN \quad \begin{array}{l} | \text{moyenne des valeurs} - \text{limite basse} | \, / \, S \\ | \text{moyenne des valeurs} - \text{limite haute} | \, / \, S \end{array}$$

Par exemple,

$$CPKo = MIN \{|Mo - \text{limite basse}| \, / \, So \; ; \; |Mo - \text{limite haute}| \, / \, So\}$$

Les termes entre deux barres verticales sont des termes pris en valeur absolue. Les limites haute et basse nécessaires au calcul de CPK sont fixées par le fabricant. Elles sont généralement exprimées en limites haute et basse du potentiel Vs lorsque celui-ci est mesuré à une date de mesure nominale Do.

Les différentes images statistiques de la population d'apprentissage sont représentées par ces critères d'appréciation CPK.

Dans une variante on peut déterminer des limites haute et basse applicables aux valeurs mesurées à des dates de mesure inférieures à la date nominale, on utilise alors une fonction de transfert pour convertir ces limites haute et basse connues. Par exemple cette fonction de transfert peut être telle que la fonction présentée à la figure 4.

Ensuite, pour choisir la date de mesure Dj, la plus précoce possible, il faut que le critère d'appréciation CPKj ou CPKjc correspondant remplisse une certaine condition vis à vis du critère d'appréciation CPKo des valeurs enregistrées à une date de mesure nominale de la population d'apprentissage.

L'invention prévoit que cette date de mesure Dj la plus précoce possible choisie au moment de la phase d'apprentissage soit éventuellement validée au cours d'une phase d'ajustage pendant la phase d'application du procédé de test selon l'invention.

En effet, chaque production, chaque lot de fabrication, chaque wafer présente une certaine homogénéité de ses caractéristiques. Ainsi, on peut choisir de définir une nouvelle date de mesure pour chaque nouveau lot de fabrication, pour chaque wafer, ou à une autre fréquence encore. Le procédé de test selon l'invention, prévoit donc avant de tester un nouveau lot de composants, une phase d'ajustage. Cette phase d'ajustage est beaucoup plus rapide que la phase d'apprentissage, et elle permet de choisir une date de mesure ajustée aux caractéristiques du lot à tester : Dma.

Ainsi, comme représenté à la figure 1, on considère une première plaquette 10 supportant des composants électroniques 20. Avant de démarrer l'analyse de la plaquette dans une phase dite d'application, on définit d'abord la date de mesure Dma au cours d'une phase d'ajustage. Au cours de cette phase d'ajustage, on teste des composants A, B de la plaquette 10, avec une date de mesure nominale Do. On attend de trouver un nombre fini et déterminé de composants électroniques conforme vis à vis du test pour pouvoir délimiter la population de la phase d'ajustage.

L'ensemble des valeurs de réponse Vs caractérisant les composants de la population d'apprentissage, comme de la population d'ajustage, peut être obtenu de manière successive après plusieurs itérations du même test avec différentes dates de mesure ou alors en un bloc grâce à l'utilisation d'un échantillonneur bloqueur.

Dans un exemple préféré, on considère une population cumulée pendant la phase d'ajustage, cette population cumulée correspondant au cumul d'une population de composants corrects, issus de la population d'apprentissage, et d'autre part de la production en cours, avec la population d'apprentissage pouvant être également issue d'une production en cours. En effet, les caractéristiques de la population d'apprentissage peuvent être conservées en mémoire sous la forme d'une base de données. Cette population d'apprentissage peut alors servir de référence pour toutes les mises au point, ou ajustages de la date de mesure qui auront lieu par la suite. Dans ce cas, la population cumulée correspond à plusieurs composants testés au fur et a mesure dans l'espace.

Dans une autre variante, la population cumulée de la phase d'ajustage correspond à un, ou à éventuellement plusieurs, composants testés avec le procédé de test selon l'invention, plusieurs fois de suite et de manière identique dans le temps.

Selon cet exemple préféré de l'invention, la population de la phase d'ajustage comporte la population d'apprentissage et des composants électroniques corrects considérés en début de lot. Par exemple, la population d'apprentissage comporte 50 composants électroniques, et la population prélevée en début de lot comporte un seul composant électronique, soit par exemple le composant électronique A de la plaquette 10. La population considérée lors de la phase d'ajustage est donc une population cumulée comportant 51 composants électroniques. Ces 51 composants électroniques sont tous acceptables pour un test effectué à une date de mesure nominale Do. Ensuite, pour ce composant électronique acceptable de la population cumulée provenant de la production en cours, on va déterminer la valeur du potentiel Vs observée pour des dates de mesures comprises entre Dj et Do. A l'obtention de chaque nouvelle mesure, on incorpore cette donnée à l'ensemble des données de la population d'apprentissage correspondant à cette même date de mesure.

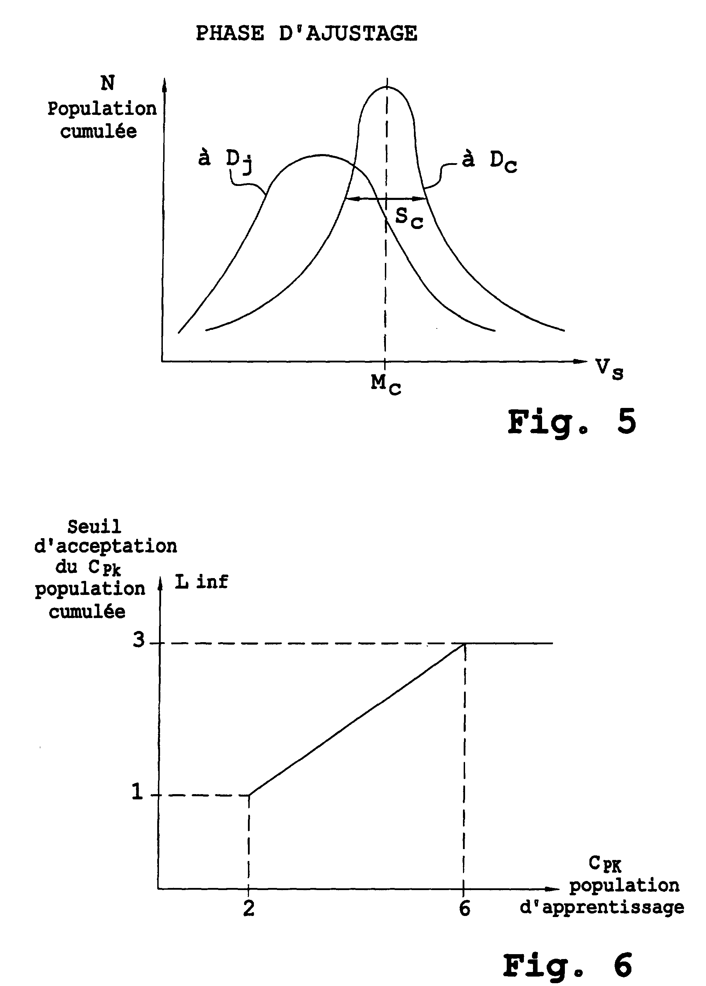

La figure 5 représente une répartition de la population cumulée en fonction de la valeur Vs lue pour une date de mesure Dc donnée. Cette répartition est caractérisée par un écart type Sc et une moyenne Mc. Alors, pour la population ainsi cumulée, on connaît Mc et Sc. En utilisant les mêmes limites d'acceptation que celles définies pour la population d'apprentissage, on calcule le coefficient d'appréciation CPKc de la population cumulée. Le coefficient d'appréciation CPKc est défini comme suit

$$CPKc = MIN \; \begin{array}{l} | \; Mc - limite \; basse \; | \; / \; Sc \\ | \; Mc - limite \; haute \; | \; / \; Sc \end{array}$$

Ensuite, pour déterminer une date de mesure ajustée Dma, on procède à une démarche, de préférence pas à pas à partir de la valeur Dj définie au cours de la phase d'apprentissage. On détermine ainsi une date de mesure ajustée Dma, Dma est supérieure ou égale à cette valeur Dj. La démarche pour trouver une valeur Dma correcte peut également être une démarche de type dichotomique.

Dans tous les cas, on choisit la valeur de la date de mesure Dma la plus précoce possible et telle que le critère d'appréciation CPKc soit supérieur à une limite inférieure Linf. Pour un coefficient CPKc calculé, correspondant à une date de mesure Dc donnée, à l'aide du graphique présenté en figure 6, on détermine la valeur de la limite inférieure Linf. Linf est déterminé en fonction de la valeur du critère d'appréciation CPK de la population d'apprentissage. Dans une première variante, Linf est déterminé en fonction du CPK de la population d'apprentissage correspondant à la date de mesure Dc considérée. Dans une deuxième variante, Linf est déterminé en fonction du critère d'appréciation CPKo obtenu pour la date de mesure nominale.

Selon le schéma présenté figure 6, pour toute valeur du coefficient d'appréciation CPK de la population d'apprentissage supérieure ou égale à 6, on tolère de choisir une date de mesure Dc telle que le coefficient d'appréciation de la population cumulée CPKc soit supérieur à la valeur 3. Généralement, pour un test dont la répétabilité est très bonne, le coefficient d'appréciation de la population d'apprentissage est de l'ordre de 1000, et donc la limite inférieure Linf utilisée est 3.

Dans un deuxième cas de figure, si la répétabilité du test est moyennement correcte, alors si le coefficient d'appréciation CPK de la population d'apprentissage est compris entre 2 et 6, la limite inférieure proposée pour le coefficient d'appréciation CPKc de la population cumulée est une fonction croissante linéaire, par exemple du type :

$$Linf = 1/2 \text{ CPK de la population d'apprentissage}$$

Dans un troisième cas de figure, si le coefficient d'appréciation CPK de la population d'apprentissage est inférieur à la valeur 2, alors cela signifie que la répétabilité du test est trop mauvaise pour que ce test puisse être optimisé, donc il n'existe pas de limite inférieure Linf à appliquer au critère CPKc de la population cumulée, car il n'y a pas d'optimisation à effectuer.

Dans l'autre variante de réalisation de l'invention, la population de la phase d'ajustage comporte uniquement des composants électroniques corrects considérés au début d'un lot de composants à tester. Par exemple, cette population comporte un seul composant A.

Pour obtenir des images statistiques à partir d'un seul composant, on effectue des itérations d'un même test, avec éventuellement des dates de mesure différentes. Dans un exemple préféré, on effectue 5 itérations du test avec la date de mesure nominale Do. On définit ainsi une image statistique nominale CPKnom de ce composant A.

$$CPKnom = MIN \quad \{ \, | \, Mnom - \text{limite basse} \, | \, / \, Snom$$
$$| \, Mnom - \text{limite haute} \, | \, / \, Snom \, \}$$

Les limites haute et basse nécessaires au calcul de ce CPK sont fixées par le fabricant. Elles sont généralement exprimées en limites haute et basse du potentiel Vs lorsque celui-ci est mesuré à une date de mesure nominale Do.

Mnom correspond à la moyenne des valeurs (Vs) obtenues au cours des 5 itérations avec la date Do. De même, Scj correspond à l'écart type de ces valeurs.

Puis on effectue 2 itérations du test sur ce même composant avec une date de mesure différente. Cette date de mesure différente peut par exemple avoir été déterminée au cours de la phase d'apprentissage et correspond alors à la date de mesure intermédiaire Dj. Cette date peut également être choisie entre Dj et Do, de manière pas à pas ou dichotomique, afin de tester une date de mesure ajustée.

Ensuite, on détermine une image statistique cumulée comportant entre autres les résultats obtenus par les itérations effectuées avec une date de mesure différente de la date de mesure nominale, et comportant les résultats obtenus suite aux itérations effectuées avec la date de mesure nominale Do. On calcule par exemple, un critère d'appréciation CPKcj défini comme suit :

$$CPKcj = MIN\{ \, |Mcj - \text{limite basse}| \, / \, Scj \, ; \, |Mcj - \text{limite haute}|/ \, Scj \}$$

Les limites haute et basse nécessaires au calcul de ce CPK sont fixées par le fabricant. Elles sont généralement exprimées en limites haute et basse du potentiel Vs lorsque celui-ci est mesuré à une date de mesure nominale Do.

Mcj correspond à la moyenne des valeurs (Vs) obtenues au cours des 5 itérations avec la date Do et des valeurs obtenues au cours des 2 itérations avec une date Dj. De même, Scj correspond à l'écart type de ces valeurs.

On accepte comme date de mesure ajustée, la date de mesure Dj testée, si l'image statistique, par exemple CPKcj, répond à certain critères. Par exemple CPKcj doit être supérieur à une tolérance pour valider la date Dj, avec cette tolérance par exemple égale à 3. Dans une variante, si CPKnom est de l'ordre de 3 à 6, cette tolérance peut être déterminée en fonction de la valeur de CPKnom. La tolérance peut alors être définie comme suit :

$$\text{Tolérance} = f1 * \text{CPKnom}$$

Avec f1 étant une valeur réelle comprise par exemple entre 0 et 1.

Dans un exemple préféré de l'invention, on réitère ce procédé d'ajustage de manière à déterminer une deuxième date de mesure ajustée Dma'. Dans ce cas, on choisit parmi les deux dates de mesure ajustées déterminées Dma et Dma', la date de mesure ajustée la plus élevée des deux. Dans cet exemple, la deuxième date de mesure ajustée est définie à partir d'une deuxième population cumulée.

Cette deuxième population cumulée est définie comme la première à partir d'un autre composant électronique que le composant A. Dans un exemple préféré de l'invention cette deuxième population de la production en cours comporte un unique composant électronique B, distinct de la première population d'ajustage.

La phase d'ajustage ainsi organisée, permet de déterminer rapidement une date de mesure ajustée à la production en cours, tout en garantissant une date de mesure ne générant pas trop de rejets inutiles, car on se sert d'informations fiables et représentatives obtenues au cours de la phase d'apprentissage. La date de mesure ajustée est alors appliquée à la production pendant la phase d'application. Par exemple on applique cette date de mesure ajustée sur un nombre donné fixe de composants électroniques à tester. Dans la figure 2, on propose de tester 2500 composants électroniques consécutifs avec la même date de mesure ajustée Dma1. Ensuite, cette première date de mesure ajustée Dma1 arrive à péremption et on procède à une nouvelle phase d'ajustage pour définir une deuxième date de mesure ajustée Dma2 pour représenter au plus près la réalité des caractéristiques de la production testée en cours.

Dans l'exemple présenté figure 4, si l'évolution de la valeur Vs est simple, on peut prévoir d'utiliser une fonction de transfert. Lorsque l'on utilise une date de mesure, quelle qu'elle soit, que ce soit une date de mesure nominale, une date de mesure intermédiaire ou une date de mesure ajustée. La fonction de transfert permet de convertir la valeur mesurée pour chaque composant électronique testé pendant la production courante en une valeur calculée du potentiel qui aurait été obtenu s'il avait été mesuré à la date de mesure nominale. Cette valeur calculée est ensuite comparée aux limites inférieure et supérieure fixées pour des mesures réalisées à cette date de mesure nominale.

Dans une variante de l'invention, on peut utiliser une fonction de transfert inverse qui permet de convertir les limites définies pour des mesures effectuées à la date de mesure nominale Do, en limites inférieure et supérieure à appliquer pour des mesures effectuées à une date de mesure ajustée. Dans ce cas de figure, il n'est pas nécessaire de convertir les valeurs mesurées pour chacun des composants.

## Revendications

1. Procédé de test de composants électroniques dans lequel :

   - on soumet à une date initiale (Di) des bornes (4) d'un composant (2) à un potentiel électrique (Vi),
   - on mesure, à une date de mesure (Dm), une valeur de potentiel (Vs) établi à des bornes (5) de ce composant, et
   - on compare cette valeur de potentiel mesurée à des limites d'acceptation, pour accepter ou rejeter le composant en fonction de cette comparaison,
   - la date de mesure est déterminée, au cours d'une phase d'apprentissage préalable à une phase d'application, au moyen d'un critère appliqué à une population de référence formée de composants acceptés, en considérant une image statistique de cette population de composants acceptés,
   - on retient comme date de mesure une date la plus précoce possible,

     **caractérisé en ce que**

   - on détermine une date de mesure ajustée au cours d'au moins une phase d'ajustage pendant la phase d'application, au moyen d'un critère de comparaison en considérant une image statistique d'une population de composants acceptés considérée au cours de la phase d'ajustage, cette population de composants acceptés étant une population cumulée comportant un cumul d'une population de référence et d'une population de composants corrects extraits de la phase d'application.

2. Procédé selon la revendication 1, **caractérisé en ce que** la population de référence est une population de composants corrects issus de la phase d'apprentissage.

**3.** Procédé selon l'une des revendications 1 à 2, **caractérisé en ce que** :

- on compare (CPKc) une image statistique obtenue à une date intermédiaire de cette population cumulée de composants acceptés avec une image statistique de la population de référence obtenue pour cette même date intermédiaire.

**4.** Procédé selon l'une des revendications 1 à 3, **caractérisé en ce que** :

- l'image statistique de la population cumulée comporte une évaluation de la moyenne (Mc) des valeurs représentées dans cette population cumulée.

**5.** Procédé selon l'une des revendications 1 à 4, **caractérisé en ce que** :

- l'image statistique de la population cumulée comporte une évaluation de l'écart type (Sc) des valeurs représentées dans cette population cumulée.

**6.** Procédé selon l'une des revendications 1 à 5, **caractérisé en ce que** :

- le critère de comparaison des images statistiques comporte une évaluation du rapport d'une première quantité, égale à la valeur absolue de la différence entre la moyenne de la population cumulée et une limite tolérée pour cette moyenne, à une deuxième quantité, égale à l'écart-type de la population cumulée.

**7.** Procédé selon l'une des revendications 1 à 6, **caractérisé en ce que** :

- on choisit une date de mesure telle que le critère de comparaison est supérieur à un seuil (Linf),
- on applique jusqu'à un nouvel ajustage de cette date de mesure ajustée choisie.

**8.** Procédé selon la revendication 7, **caractérisé en ce que**

- on choisit le seuil en appliquant une fonction linéaire à une valeur d'un deuxième rapport entre une valeur absolue de la différence entre une moyenne de la population de référence et une limite tolérée pour cette moyenne, et un écart type de cette population de référence.

**9.** Procédé selon la revendication 8, **caractérisé en ce que** la fonction linéaire comporte une première forme linéaire croissante sur un premier intervalle de valeur du deuxième rapport, et une deuxième forme linéaire constante sur un deuxième intervalle de ce deuxième rapport.

**10.** Procédé selon l'une des revendications 1 à 9, **caractérisé en ce que** :

- on détermine pour la date de mesure ajustée choisie les limites d'acceptation à appliquer aux valeurs de potentiel des composants à tester, et on retient comme bons des composants dont les valeurs mesurées, à la date de mesure sont compatibles avec ces limites d'acceptation.

**11.** Procédé selon l'une des revendications 1 à 9, **caractérisé en ce que** :

- on procède à une nouvelle phase d'ajustage de la date de mesure après avoir utilisé la date de mesure déterminée sur un nombre de composants donné.

**12.** Procédé selon l'une des revendications 1 à 11, **caractérisé en ce que** :

- on effectue des itérations successives du procédé pour déterminer la date de mesure la plus précoce possible,
- on considère à chaque itération une nouvelle population de composants acceptables extraits de la phase d'application,
- on choisit la date de mesure la plus tardive proposée par chacune des itérations.

**13.** Procédé selon la revendication 12, **caractérisé en ce que**

- on effectue deux itérations, et

- on considère, à chaque itération, une population de composants acceptés comportant un seul composant accepté.

**Claims**

1. A method for the testing of electronic components in which

   - terminals (4) of a component (2) are subjected, at an initial date (Di), to an electric potential (Vi),
   - a value of potential (Vs) set up at terminals (5) of this component is measured at a measurement date (Dm), and
   - this measured value of potential is compared with limits of acceptance, in order to accept or reject the component as a function of this comparison,
   - the measurement date is determined, during a learning phase preliminary to an application phase, by means of a criterion applied to a reference population of accepted components, in considering a statistical image of this population of accepted components,
   - the earliest possible date is chosen as a measurement date,

     wherein:

   - the measurement date determined is adjusted in the course of at least one adjustment phase during the application phase, by means of a comparison criterion, in considering a statistical image of a population of accepted components considered during the adjustment phase, this population of accepted components considered is a totalized population comprising a total of a reference population and a population of acceptable components taken out of an application phase.

2. A method according to claim 1, wherein the reference population is a population of acceptable components coming from the learning phase.

3. A method according to one of the claims 1 to 2, wherein

   - a statistical image (CPKc), obtained at an intermediate date, of this totalized population of accepted components is compared with a statistical image of the reference population obtained for this same intermediate date.

4. A method according to the one of claims 1 to 3, wherein

   - the statistical image of the totalized population comprises an evaluation of the mean (Mc) of the values represented in this totalized population.

5. A method according to the one of claims 1 to 4, wherein

   - the statistical image of the totalized population comprises an evaluation of the standard deviation (Sc) of the values represented in this totalized population.

6. A method according to one of claims 1 to 5, wherein

   - the criterion of comparison of the statistical images comprises an evaluation of the ratio between a first quantity, equal to the absolute value of the difference between the mean of the totalized population and a limit tolerated for this mean, and a second quantity, equal to the standard deviation of the totalized population.

7. A method according to one of claims 1 to 6, wherein

   - a measurement date is chosen such that the criterion of comparison is above a threshold (Linf),
   - it is applied until a new adjustment of this chosen adjusted measurement date.

8. A method according to one of claims 1 to 7, wherein

   - the threshold is chosen by applying a linear function to a value of a second ratio between an absolute value of the difference between a mean of the reference population and a limit tolerated for this mean, and a standard deviation of this population of reference.

9. A method according to claim 8, wherein the linear function comprises a first increasing linear form on a first interval of value of the second ratio, and a second constant linear form on a second interval of this second ratio.

10. A method according to the one of claims 1 to 9 wherein

- for the selected measurement date, the limits of acceptance to be applied to the values of potential of the components to be tested are chosen, and components whose measured values, on the measurement date, are compatible with these limits of acceptance are chosen as acceptable.

11. A method according to one of claims 1 to 9, wherein

- a new adjustment phase of the measurement date is carried out after using the chosen measurement date on a given number of components.

12. A method according to the one of claims 1 to 11 wherein

- successive iterations of the method are performed to determine the earliest possible measurement date,
- at each iteration a new population of acceptable components extracted from the production of the current phase are considered,
- the latest measurement date proposed by each iteration is chosen.

13. A method according to the claim 12 wherein:

- two iterations are performed, and
- at each iteration, a population of accepted components comprising only one accepted component is considered.

**Patentansprüche**

1. Testverfahren für elektronische Komponenten, bei dem:

- Anschlüsse (4) einer Komponente (2) zu einem ersten Zeitpunkt (Di) an ein elektrisches Potential (Vi) angeschlossen werden,
- zu einem Meßzeitpunkt (Dm) in an den Anschlüssen (5) dieser Komponente anliegender Potentialwert (Vs) gemessen wird, und
- dieser gemessene Potentialwert mit Akzeptanzgrenzen verglichen wird, um die Komponente in Abhängigkeit von diesem Vergleich anzunehmen oder zu verwerfen,
- der Meßzeitpunkt im Laufe einer Lernphase, die vor einer Anwendungsphase liegt, durch ein Kriterium bestimmt wird, das auf eine durch die angenommenen Komponenten gebildete Referenzpopulation angewendet wird, indem ein statistisches Bild dieser Population der angenommenen Komponenten betrachtet wird,
- als Meßzeitpunkt der frühestmögliche Meßzeitpunkt festgehalten wird,

**dadurch gekennzeichnet, daß**
bei mindestens einer Anpassungsphase während der Anwendungsphase durch ein Vergleichskriterium ein angepaßter Meßzeitpunkt bestimmt wird, indem ein statistisches Bild einer Population der angenommenen Komponenten betrachtet wird, das während der Anpassungsphase betrachtet wird, wobei die Population der angenommenen Komponenten eine Summen-Population ist, die die Summe einer Referenzpopulation und einer Population von richtigen Komponenten aufweist, die bei der Anwendungsphase extrahiert wurden.

2. Verfahren nach Anspruch 1, **dadurch gekennzeichnet, daß** die Referenzpopulation eine Population von richtigen Komponenten ist, die aus der Lernphase kommen.

3. Verfahren nach einem der Ansprüche 1 oder 2, **dadurch gekennzeichnet, daß** das zu einem Zwischenzeitpunkt erhaltene statistische Bild dieser Summen-Population von angenommenen Komponenten mit einem statistischen Bild der Referenzpopulation verglichen wird (CPKc), das für den gleichen Zwischenzeitpunkt erhalten wurde.

4. Verfahren nach einem der Ansprüche 1 bis 3, **dadurch gekennzeichnet, daß** das statistische Bild der Summen-Population die Berechnung des Mittelwertes (Mc) der in dieser angehäuften Population dargestellten Werte aufweist.

5. Verfahren nach einem der Ansprüche 1 bis 4, **dadurch gekennzeichnet, daß** das statistische Bild der Summen-Population eine Berechnung der Standardabweichung (Sc) der dargestellten Werte in dieser Summen-Population aufweist.

6. Verfahren nach einem der Ansprüche 1 bis 5, **dadurch gekennzeichnet, daß** das Vergleichskriterium der statistischen Bilder eine Berechnung des Verhältnisses einer ersten Größe, die dem Absolutwert der Differenz zwischen dem Mittelwert der Summen-Population und einem tolerierten Grenzwert für diesen Mittelwert entspricht, zu einer zweiten Größe aufweist, die der Standardabweichung der Summen-Population entspricht.

7. Verfahren nach einem der Ansprüche 1 bis 6, **dadurch gekennzeichnet, daß**

   - ein Meßzeitpunkt ausgewählt wird, sobald das Vergleichskriterium oberhalb einer Grenze (Linf) liegt,
   - bis zu einer neuen Anpassung dieser ausgewählte angepaßte Meßzeitpunkt verwendet wird.

8. Verfahren nach Anspruch 7, **dadurch gekennzeichnet, daß** die Grenze ausgewählt wird, indem eine lineare Funktion auf einen Wert eines zweiten Verhältnisses zwischen einem Absolutwert der Differenz zwischen einem Mittelwert der Referenzpopulation und einem tolerierten Grenzwert für diesen Mittelwert, und einer Standardabweichung dieser Referenzpopulation angewendet wird.

9. Verfahren nach Anspruch 8, **dadurch gekennzeichnet, daß** die lineare Funktion in einem ersten Werteabschnitt des zweiten Verhältnisses der Gleichung zweiten Grades linear ansteigt, und in einem zweiten Abschnitt dieses zweiten Verhältnisses konstant ist.

10. Verfahren nach einem der Ansprüche 1 bis 9, **dadurch gekennzeichnet, daß** für den ausgewählten angepaßten Meßzeitpunkt die Akzeptanzgrenzen bestimmt werden, die auf Spannungswerte der zu untersuchenden Komponenten angewendet werden und diese Komponenten für gut zurückgehalten werden, deren Meßwerte zum Meßzeitpunkt mit den Akzeptanzgrenzen verträglich sind.

11. Verfahren nach einem der Ansprüche 1 bis 9, **dadurch gekennzeichnet, daß** zu einer neuen Anpassungsphase des Meßzeitpunkts übergegangen wird, nachdem der festgelegte Meßzeitpunkt auf eine gegebene Anzahl von Komponenten angewendet wurde.

12. Verfahren nach einem der Ansprüche 1 bis 11, **dadurch gekennzeichnet, daß**

   - aufeinanderfolgende Iterationsschritte des Verfahrens ausgeführt werden, um das frühestmögliche Meßdatum zu bestimmen,
   - bei jeder Iteration eine neue Population von angenommenen Komponenten berücksichtigt wird, die bei der Anwendungsphase extrahiert wurden,
   - als Meßdatum das späteste Datum ausgewählt wird, das bei jeder der Iterationen vorgeschlagen wurde.

13. Verfahren nach Anspruch 12, **dadurch gekennzeichnet, daß**

   - zwei Iterationsschritte durchgeführt werden, und
   - bei jeder Iteration eine Population von angenommenen Komponenten berücksichtigt wird, die eine einzige angenommene Komponente aufweisen.

POPULATION
D'APPRENTISSAGE

PRODUCTION
EN COURS DE
TEST

# Fig. 1

## PHASE D'APPRENTISSAGE

Fig. 3

## PHASE D'APPRENTISSAGE

Fig. 4

PHASE D'AJUSTAGE

Fig. 5

Fig. 6